# EUROPEAN PATENT APPLICATION

(11) **EP 4 195 288 A1**
(43) Date of publication of application: **14.06.2023**
(21) Application number: 22205784.6
(22) Date of filing: 07.11.2022
(51) Int. Cl.: H01L 29/423, H01L 29/06, H01L 29/775, H01L 29/08, H01L 29/45, H01L 29/78, H01L 29/165, H01L 21/225, H01L 21/336, H01L 21/8234, H01L 27/06, H01L 29/66, B82Y 10/00

(54) **WRAP-AROUND CONTACT WITH REDUCED RESISTANCE**

(30) Priority: 10.12.2021 US 202117547980
(71) Applicant: INTEL Corporation, Santa Clara, CA 95054 (US)
(72) Inventor: Majhi, Prashant, San Jose, 95121 (US); Murthy, Anand, Portland, 97229 (US); Killampalli, Aravind S., Portland, 97229 (US)
(74) Representative: Goddar, Heinz J.

(57) **Abstract**

An integrated circuit includes a body of semiconductor material. A source or drain region includes semiconductor material in contact with the body, where the semiconductor material of the source or drain region includes an outer region having a dopant concentration that is greater than a remaining region of the source or drain region, the outer region defining multiple contact surfaces of the source or drain region and extending into the source or drain region to a depth of at least 1 nm. A contact comprising a metal is on the multiple contact surfaces of the source or drain region. The dopant concentration of the outer region is continuous along the entire interface between the contact and the outer region, according to an example.

## Description

### BACKGROUND

Semiconductor devices are electronic components that exploit the electronic properties of semiconductor materials, such as silicon (Si), germanium (Ge), gallium arsenide (GaAs), and indium phosphide (InP). A field-effect transistor (FET) is a semiconductor device that includes three terminals: a gate, a source, and a drain. A FET uses an electric field applied by the gate to control the electrical conductivity of a channel through which charge carriers (e.g., electrons or holes) flow between the source and drain. In instances where the charge carriers are electrons, the FET is referred to as an n-channel device, and in instances where the charge carriers are holes, the FET is referred to as a p-channel device. A metal-oxide-semiconductor FET (MOSFET) includes a gate dielectric between the gate and the channel. MOSFETs may also be known as metal-insulator-semiconductor FETs (MISFETSs) or insulated-gate FETs (IGFETs). Complementary MOS (CMOS) structures use a combination of p-channel MOSFET (PMOS) and n-channel MOSFET (NMOS) devices to implement logic gates and other digital circuits.

A FinFET is a MOSFET transistor built around a thin strip of semiconductor material that is generally referred to as a fin. The conductive channel of the FinFET device resides on the outer portions of the fin adjacent to the gate dielectric. Specifically, current runs along/within both sidewalls of the fin (sides perpendicular to the substrate surface) as well as along the top of the fin (side parallel to the substrate surface). Because the conductive channel of such configurations includes three different planer regions of the fin (e.g., top and two sides), such a FinFET design is sometimes referred to as a tri-gate transistor. A nanowire or nanoribbon transistor (sometimes referred to as a gate-all-around (GAA) transistor) is configured similarly to a fin-based transistor, but instead of a finned channel region with the gate is contact with three sides of the fin, one or more nanowires extend between the source and the drain regions. In nanowire transistors the gate material generally surrounds or encircles each nanowire (hence, gate-all-around).

### BRIEF DESCRIPTION OF THE DRAWINGS

FIG. 1 illustrates a cross section taken through the source/drain contact of a fin-based transistor structure and shows a source/drain material with an outer region of higher dopant concentration, in accordance with an embodiment of the present disclosure.
FIG. 2 illustrates a cross section taken through the source/drain contact of a nanoribbon transistor structure and shows a source/drain material with an outer region of higher dopant concentration, in accordance with another embodiment of the present disclosure.
FIG. 3 illustrates a cross section taken through the source/drain contacts of a stacked nanoribbon transistor structure and shows upper and lower source/drain materials each with an outer region of higher dopant concentration, in accordance with an embodiment of the present disclosure.
FIG. 4 illustrates a graph of dopant density vs. material depth for source/drain material, in accordance with an embodiment of the present disclosure.
FIG. 5 illustrates a method of forming a contact on source/drain material having a highly doped outer region, in accordance with an embodiment of the present disclosure.
FIGS. 6A-6F illustrate views finned transistor structures at various stages of source/drain contact processing, in accordance with some embodiments of the present disclosure.
FIG. 6G illustrates an alternate embodiment of that shown in FIG. 6F, in accordance with an embodiment of the present disclosure.
FIG. 7A-7F illustrate views of a nanoribbon transistor structure at various stages of source/drain contact processing, in accordance with some embodiments.
FIG. 8 illustrates a method of fabricating an integrated circuit with a transistor structure, in accordance with an embodiment of the present disclosure.
FIG. 9 illustrates a computing system that can implement transistor structures fabricated according methodologies disclosed herein.

The figures depict various embodiments of the present disclosure for purposes of illustration only. Numerous variations, configurations, and other embodiments will be apparent from the following detailed discussion. Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., tapered sidewalls and rounded corners), and some features may have surface topology or otherwise be non-smooth, given real-world limitations of the processing equipment and techniques used.

### DETAILED DESCRIPTION

Disclosed herein are structures and methodologies for reducing contact resistance in transistor structures, such as the contact resistance at the source and/or drain regions. In accordance with one embodiment, an integrated circuit includes a body of semiconductor material and a source or drain (source/drain) of semiconductor material on an end portion of the body. For example, the body is a fin or plurality of nanoribbons (or nanosheets or nanowires, as the case may be) that extend between source and drain regions. Semiconductor material at the source and drain may exhibit side-facing or downward-facing surfaces that are difficult to dope with ion-beam implantation or similar techniques. For example, whether epitaxially grown over part of a fin or over nanoribbons, or regrown in a replacement source/drain approach, the epitaxial material may have a faceted shape (e.g., diamond or pentagon cross-sectional shape with one or more downward-facing surfaces). According to an embodiment of the present disclosure, applying a monolayer of dopant atoms to the source/drain material, followed by annealing, effectively drives the dopant molecules into the surface of the source/drain material. The result is a source/drain material that includes an outer region having a dopant concentration. For instance, in some embodiments, the source region and the drain region of a given device each have an outer region having a dopant concentration of at least 1E19 atoms/cm³ to a depth of at least 10 nm, the outer region extending along, for example, at least one side-facing or downward-facing surface of the source/drain. An electrical contact formed on the source/drain can benefit from reduced contact resistance due to the high doping concentration at the surface of the source/drain. In particular, a wrap-around contact (WAC) can be used to make contact with highly doped regions not only at top or upward-facing surfaces of the source/drain, but also with side-facing and downward-facing surfaces, as the case may be.

A method of forming a source/drain contact is also disclosed. In one embodiment, the method includes applying one or more monolayers of dopant molecules to the surface of the source/drain material. In some cases, the one or more monolayers can be capped with an oxide or nitride. The monolayer is annealed to drive the dopant molecules into the surface of the source/drain material. After removing the capping material, if present, a source/drain contact can be formed on the source/drain material. In some embodiments, the contact is a wrap-around contact that abuts one or more side-facing or downward-facing surface of the source/drain material. For gate-all-around configurations, the contact can wrap all the way around the source/drain.

### GENERAL OVERVIEW

Field effect transistors (FETs) have been scaled to smaller and smaller sizes to achieve faster circuit operation. Such scaling has resulted in the development of the nanowire and nanoribbon transistors or gate-all-around (GAA) transistors, and forksheet transistors. For example, the GAA channel region can have one or more nanowires extending between the source and drain regions, such as a vertical stack of nanowires that extend horizontally between the source and drain regions. Electrical contacts with the source and drain regions involve a metal-semiconductor junction. This junction exhibits a Schottky barrier, which is the potential energy barrier, that must be overcome for current to flow between the metal and the semiconductor. Some possible approaches to reducing the Schottky barrier include applying a layer of resistance-reducing material in the metal-semiconductor junction, or doping the surface of the semiconductor material of the source or drain region, an adhesion layer.

For example, ion beam implantation injects dopants in a linear path downward into exposed upward-facing surfaces of material. However, such a process does not implant dopants into downward-facing or side-facing surfaces, obstructed surfaces, or other surfaces requiring the ions to take a non-linear path. As such, the active doping concentration along the surface of the source and drain is limited (e.g., non-conformal and non-uniform). Therefore, it would be desirable to utilize an improved doping methodology that enables high dopant concentrations to be realized on all exposed surfaces of source/drain material, including upward-facing, downward-facing, side-facing, and recessed surfaces.

Thus, methodologies are provided herein for doping semiconductor material, particularly the source and drain regions of a transistor structure. Although the techniques can be used in any number of configurations, they are particularly useful to dope source/drain material upon which wrap-around contacts will be deposited, such as applicable to nanowire, nanoribbon, and fin-based transistor structures, for example. In accordance with some embodiments, a monolayer (or several monolayers) can be applied to all exposed surfaces of the source/ drain material, then annealed to drive the dopant molecules into the semiconductor material to result in a highly doped layer at the surface of the material. Such an approach is different from existing doping approaches in that it is effective on exposed top, bottom, side-facing surfaces, and other surfaces, some of which would not be accessible using ion beam implantation techniques, for example. The techniques can be used to achieve relatively high concentration of dopant molecules in a relatively conformal outer surface layer of the semiconductor material (e.g., ~5-20 nm depth). For example, the dopant concentration may be highest at the surface and reduce gradually with depth into the semiconductor material. In some embodiments, the doped material has a peak dopant concentration at or near the surface of at least 1E19/cm³ or greater, including concentrations of 1E20/cm³, 1E21/cm³, or greater. The techniques can be combined with other approaches to reduce the contact resistance, including the use of workfunction metals and/or other materials applied to the surface of the source or drain material prior to depositing the contact metal.

The use of "Group IV semiconductor material" (or "Group IV material" or generally, "IV") herein includes at least one Group IV element (e.g., silicon, germanium, carbon, tin), such as silicon (Si), germanium (Ge), silicon-germanium (SiGe), and so forth. The use of "Group III-V semiconductor material" (or "Group III-V material" or generally, "III-V") herein includes at least one Group III element (e.g., aluminum, gallium, indium) and at least one Group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), gallium nitride (GaN), and so forth. Note that Group III may also be known as the boron group or IUPAC Group 13, Group IV may also be known as the carbon group or IUPAC Group 14, and Group V may also be known as the nitrogen family or IUPAC Group 15, for example.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. If two materials are elementally different or distinct, then one of the materials has an element that is not in the other material.

Note that the use of "source/drain region" or "source/drain regions" herein is intended to refer to a source region or a drain region or both a source region and a drain region, respectively. To this end, the forward slash ("/") as used herein is not intended to implicate any particular structural limitation or arrangement with respect to source and drain regions, or any other materials or features that are listed herein in conjunction with a forward slash.

Note further that the use of "wrap-around contact" as used herein refers to an electrical contact that makes contact with or is on multiple surfaces (e.g., one or more side-facing surfaces and/or one or more downward-facing surfaces and/or one or more upward-facing surfaces) of a particular feature, such as a source or drain region of a transistor structure. To this end, directional terms "upward," "up," "downward," "down," and the like are used with reference to such a feature extending upward from an imaginary horizontal plane. Similarly, "side-facing" indicates a face that has a generally vertical orientation.

In some embodiments, a plurality of channel layers of compositionally different channel materials or geometries may be formed on different areas of the substrate, such as for CMOS applications, for example. For instance, a first channel material layer may be formed on a first area of a given die to be used for one or more p-channel transistor devices (e.g., one or more PMOS devices) and a second channel material layer may be formed on a second area of the die to be used for one or more n-channel transistor devices (e.g., one or more NMOS devices).

In some embodiments, the techniques described herein can be used to benefit n-channel devices (e.g., NMOS) and/or p-channel devices (e.g., PMOS). Further, in some embodiments, the techniques described herein can be used to benefit a multitude of transistor devices, such as planar and non-planar configurations, where example non-planar configurations include finned or FinFET configurations (e.g., double-gate or tri-gate), gate-all-around (GAA) configurations (e.g., nanowire or nanoribbon), forksheet transistor configurations, or some combination thereof (e.g., beaded-fin configurations), to provide a few examples. In addition, in some embodiments, the techniques can be used for a variety of source/drain (S/D) configurations, such as replacement material S/D, cladded S/D, and/or any other suitable S/D configuration as will be apparent in light of this disclosure. The techniques described herein may be used to benefit logic and memory transistor devices or transistor-based devices used for other suitable applications (e.g., amplification, switching, etc.). Further still, in some embodiments, the techniques described herein can be used to form complementary transistor circuits (such as CMOS circuits), where the techniques can be used to benefit one or more of the included n-channel and p-channel transistors making up the CMOS circuit.

In general, the techniques allow transistors to be further scaled with diverse channel materials, while ensuring higher operating voltage, higher drive currents, and thereby improved performance. Further still, any such devices may employ semiconductor materials that are three-dimensional crystals as well as two dimensional crystals or nanotubes, for example. In some embodiments, the techniques may be used to benefit devices of varying scales, such as IC devices having critical dimensions in the micrometer (micron) range and/or in the nanometer (nm) range (e.g., formed at the 22, 14, 10, 7, 5, or 3 nm process nodes, or beyond).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools may indicate a source/drain material that includes a highly doped and conformal region at the surface, where the dopant concentration reduces with depth into the material. In some embodiments, the techniques described herein may be detected based on the benefits derived from their use, source/drain contacts with reduced contact resistance, relatively higher operating voltage, relatively higher drive currents, and/or other improved device performance. Numerous configurations and variations will be apparent in light of this disclosure.

### EXAMPLE STRUCTURES

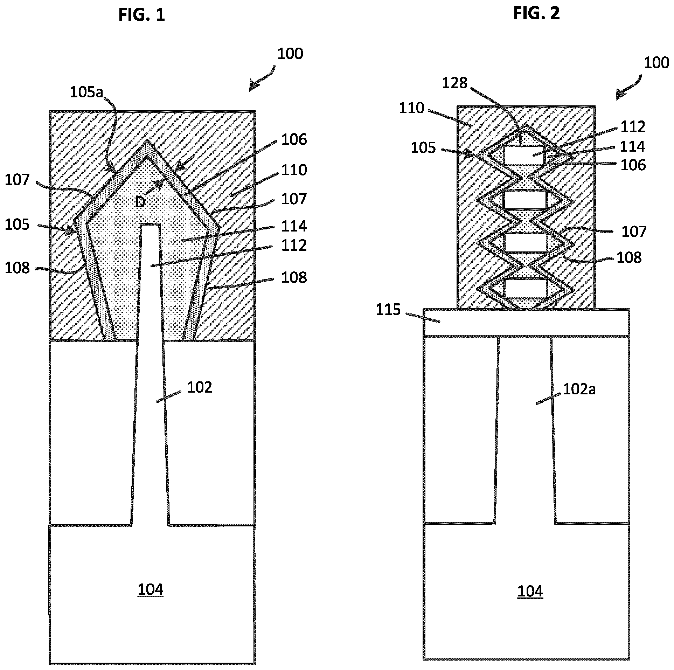

FIG. 1 illustrates a cross-sectional view of a source/drain 105 of a transistor structure 100, in accordance with an embodiment of the present disclosure. In this example, the transistor structure 100 includes a fin 102 of semiconductor material extending up from a base 104, which may be the same or different material as the fin 102. The source/drain 105 includes source/drain material 114 on an upper part of the fin 102, also referred to as a seed or core 112. The source/drain material 114 abuts or makes contact with the top and sides of the fin 102. In other embodiments, such as when the source/drain 105 is a replacement source/drain 105, the source/drain material 114 may not include a core 112 (e.g., part of fin 102 or nanoribbon), but instead may abut or otherwise contact an end face of the portion of the fin 102 defining a channel region of the transistor, for example.

A contact 110 of metal or other suitable conductive material is on and wraps around the source/drain 105. In more detail, the contact 110 shown in this example is a wrap-around contact 110 that contacts both upward-facing surfaces 107 and downward-facing surfaces 108 (or parts thereof) of the source/drain 105, which generally has a pentagonal cross-sectional shape in this example. The source/drain 105 can have other cross-sectional shapes depending on the geometry of seed material or core 112, crystal orientation, chemical composition, epitaxial parameters, and other factors, as will be appreciated. In a more general sense, the source/drain 105 may be faceted or not, and may have any shape that includes multiple contact surfaces (e.g., such as the multiple surfaces of a feature having a rectangular, square, triangular, trapezoidal, rhombus, or curvilinear shape, in cross-section).

The source/drain material 114 includes an outer region 106 of high dopant concentration N_{d}, the outer region 106 extending a depth D into the source/drain material 114 from the outer surface 105a. In some embodiments, the outer layer 106 has a dopant concentration N_{d} of at least 1E19 atoms/cm³ to a depth D of at least 10 nm, including at least 15 nm, and at least 20 nm. In some embodiments, the dopant concentration N_{d} is at least 1E20 atoms/cm³, at least 1E21 atoms/cm³, or greater, and exhibits that dopant concentration N_{d} to a depth D of at least 10 nm, 15 nm, 20 nm, or more. In some embodiments, the source/drain 105 has a peak dopant concentration N_{d, peak} that occurs at the outer surface 105a, or within 5 nm, or within 10 nm of the outer surface 105a, of the source/drain 105, where the peak dopant concentration N_{d, peak} is at least 1E19 atoms/cm³. In this sense, outer region 106 can be considered conformal to all contact surfaces of the source/drain 105, given that the depth and concentration N_{d} is relatively consistent along all contact surfaces of source/drain 105, according to some embodiments. In other such embodiments, the peak dopant concentration N_{d, peak} is at least 1E20 atoms/cm³, at least 1E21 atoms/cm³, or at least 1E22 atoms/cm³. The depth of concentration N_{d} can vary from one embodiment to the next, but in some cases is in the range of about 5 angstroms (0.5 nm) to about 10 nm (e.g., one to several monolayers, or more). This conformal outer region can further be thought of as the relatively high-dopant concentration, while the remaining inner portion of source/drain 105 can be doped as some lower concentration, according to some examples.

FIG. 2 illustrates a cross-sectional view of a transistor structure 100 showing a contact 110 on the source/drain 105 of vertically stacked nanoribbon transistors, in accordance with an embodiment of the present disclosure. In this example, the transistor structure 100 includes four nanoribbons 128 arranged one above the other in a vertical stack. Other embodiments may include fewer nanoribbons 128 (e.g., one or two or three) or more nanoribbons 128 (e.g., five or six). The source/drain 105 includes source/drain material 114 of a second semiconductor material around a core 112 (e.g., a nanoribbon, nanowire, nanosheet, etc.) of a first semiconductor material. For example, the source/drain material 114 is epitaxially grown on the nanoribbon 128 as the core 112 of the first semiconductor material to provide a source/drain 105 that includes both the first and second semiconductor materials. The first semiconductor material can be, but is not required to be, compositionally distinct from the second semiconductor material. In some such embodiments, for example, the first semiconductor material is single-crystal silicon (e.g., undoped or minimally doped with N_{d} ~ 1E12 atoms/cm³) and the second semiconductor material is doped silicon (e.g., N_{d} ~ 1E16 atoms/cm³), silicon germanium (SiGe), silicon carbide, or other material. Numerous other materials combinations can be used, as will be appreciated.

As shown in the example of FIG. 2, each core 112 is a nanoribbon 128 having a generally rectangular cross-sectional shape and the source/drain material 114 around it generally has a diamond cross-sectional shape. As previously explained above, other shapes may be formed as well, given factors such as real-world process limitations, and/or different crystalline growth patterns (faceting), and/or constraints that inhibit faceting such as side-wall spacers that constrain at least a portion of epitaxial growth to the vertical direction thereby producing growth features have vertical sidewalls (e.g., nitride gate spacer that deposits on the sides of gate structure as well as on sides of the fin structure in the source/drain regions and thus constrains epitaxial growth in the source and drain regions to the vertical direction), and/or processing that removes faceting such as a planarization process to an upper faceted portion of a given feature (e.g., chemical mechanical planarization, or CMP, that removes faceting of the source/drain regions that extends above the gate spacer). Similar to as discussed above with reference to FIG. 1, the source/drain material 114 includes an outer region 106 that is highly doped (e.g., N_{d} at least 1E19 atoms/cm³), relative to the inner portion of source/drain 105. Here, the source/drain material 114 around the spaced-apart nanoribbon cores 112 is continuous among vertically adjacent cores 112. A layer of isolation material 115 is between and isolates the fin stub 102a from the bottom source/drain 105, to improve subfin isolation.

The contact 110 is a wrap-around contact that contacts multiple surfaces of source/drain 105, which in this example case include both upward-facing surfaces 107 and downward-facing surfaces 108. As previously explained, the multiple surfaces can vary from one embodiment to the next, given factors such as epitaxial growth patterns and processing. For instance, in another embodiment, the multiple surfaces may include a relatively horizontal top surface and relatively vertical side surfaces (e.g., such as a rectangular or square shape, or a slightly tapered shape).

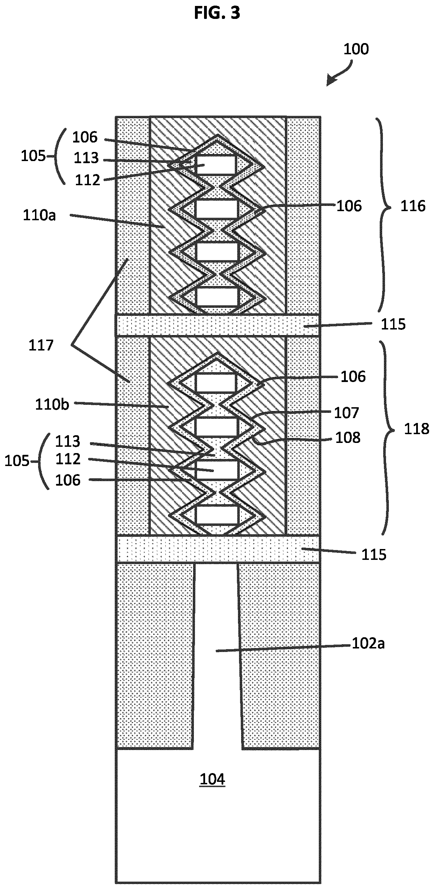

FIG. 3 illustrates a cross-sectional view through the upper and lower source/drain regions 105 of a stacked transistor structure 100, in accordance with an embodiment of the present disclosure. As can be seen in this example case, upper transistor device 116 includes four cores 112, as does lower transistor device 118. In this example, the cores 112 are nanoribbons that are aligned with the fin stub 102a as having been fabricated from part of the fin using a layered material approach. The upper transistor device 116 is isolated and spaced from the lower transistor device 118 by a layer of isolation material 115, although this is not required. For example, in some cases the upper and lower source/drain region 105 are connected to one another so as to provide a single monolithic source/drain 105. A layer of isolation material 115 also separates the lower transistor device 118 from the underlying fin stub 102a, to improve subfin isolation. Contacts 110a and 110b are isolated laterally by isolation material 117, such as an oxide, a nitride, or other suitable material.

Each source/drain 105 includes a nanoribbon core 112 of a first semiconductor material that is surrounded by source/drain material 114 of a second semiconductor material that includes an outer layer 106 of high dopant concentration. In this example, wrap-around contact 110a is on multiple surfaces of source/drain 105 of the upper transistor device 116, and wrap-around contact 110b is on multiple surfaces of source/drain 105 of the lower transistor device 118. As discussed above with reference to FIG. 2, each contact 110a, 110b contacts upward-facing surfaces 107 and downward-facing surfaces 108 of the sources/drains 105. In other embodiments, a single monolithic contact 110 can be common to source/drain 105 of both the upper and lower transistor devices 116, 118, in which case there may be no intervening layer of isolation material 115 between the upper and lower source/drain regions 105.

In one embodiment, the source/drain region 105 of the upper transistor device 116 is one polarity (e.g., n-type) and the source/drain region 105 of the lower transistor device 118 is an opposite polarity (e.g., p-type). In some such embodiments, the transistor structure 100 is part of a complementary metal oxide semiconductor (CMOS) circuit. Numerous variations and embodiments will be apparent in light of the present disclosure.

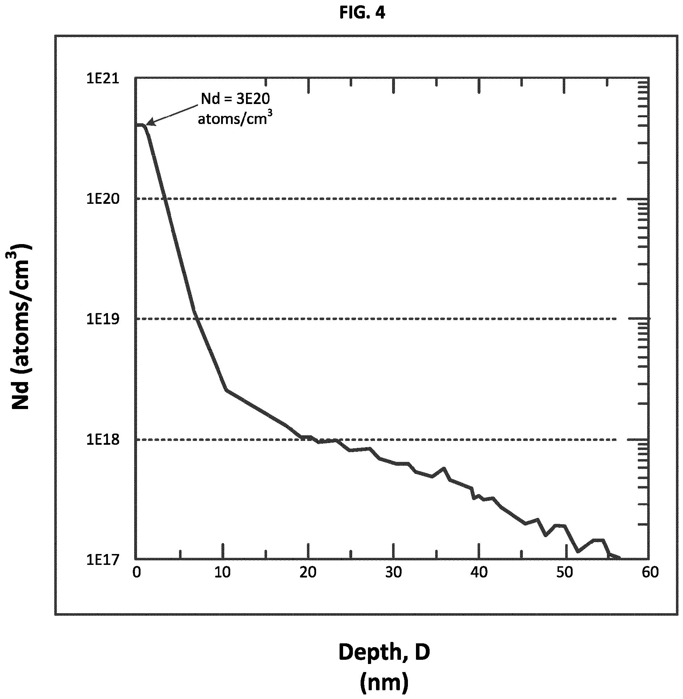

Referring now to FIG. 4, dopant concentration N_{d} (atoms/cm³) is plotted against depth D (nm) for the source/drain material 114, in accordance with an embodiment of the present disclosure. The dopant concentration profile shown in FIG. 4 is a result of monolayer doping methodologies, in accordance with an embodiment of the present disclosure. In this particular example, the dopant concentration N_{d} is at least 1E19 atoms/cm³ to a depth of about 7 nm and has a peak dopant concentration N_{d, peak} of about 3E20 atoms/cm³ occurs from depth D from 0 to 1 nm. Note that the peak dopant concentration N_{d, peak} exhibits a plateau or consistent value for depths from 0 to 1 nm in this example. The dopant concentration N_{d} falls off relatively quickly to 2E18 atoms/cm³ at a depth of about 10 nm, then continues to fall off at a more gradual rate to 1E18 atoms/cm³ at a depth D of about 20 nm, and then reduces more gradually still at depths beyond 20 nm.

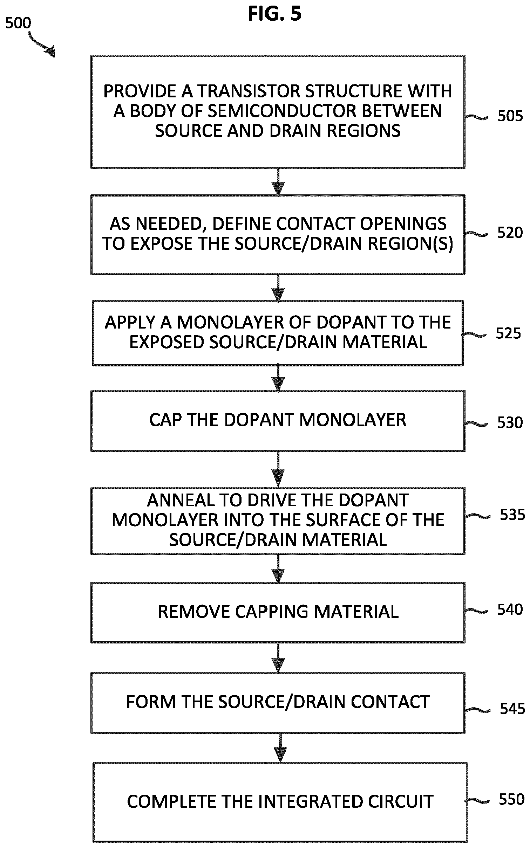

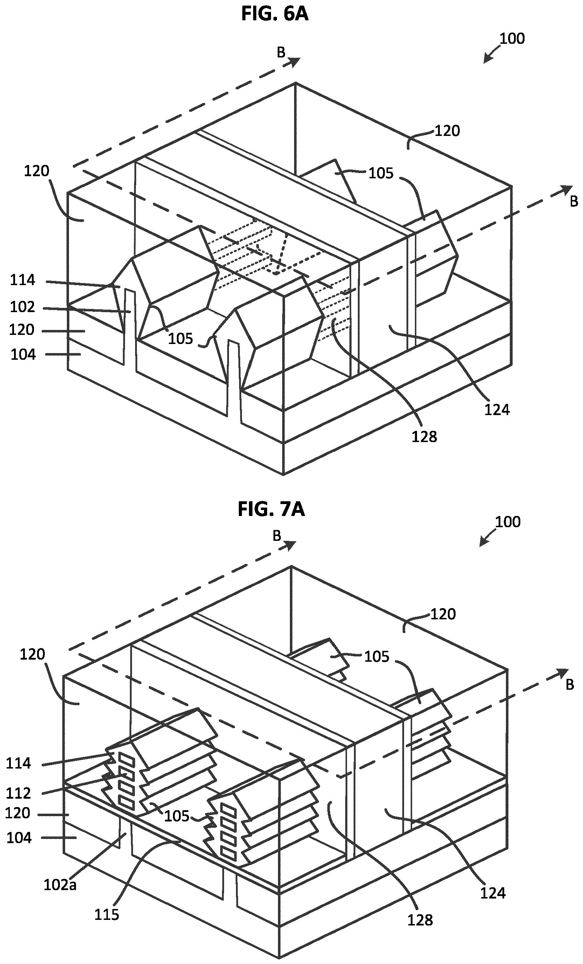

FIG. 5 illustrates processes in a method 500 of forming a source/drain contact, in accordance with an embodiment of the present disclosure. Method 500 can be performed to provide a source/drain material that includes a highly doped outer region upon which a contact can be formed. Method 500 can be implemented with gate-all-around transistor structures having one or more nanowires, nanoribbons, or similar semiconductor structure, fin-based transistors, planar transistor structures, and stacked transistor structures. FIGS. 6A-6G illustrate examples of finned transistor structures at various stages of fabrication, in accordance with some embodiments of the present disclosure. FIGS. 7A-7F illustrate examples of nanoribbon transistor structures at various stages of fabrication, in accordance with some embodiment of the present disclosure. FIGS. 6A-6G and 7A-7F will be discussed in tandem with processes of method 500.

Method 500 can be performed for a single source/drain contact, or can be performed for a plurality (e.g., several, tens, hundreds, thousands, ...) of source/drain contacts at the same time. In some embodiments, a plurality of nanowires or nanoribbons can be arranged in a vertical stack. In one such embodiment, such as for a CMOS circuit, some of the transistors of the vertical stack are configured as NMOS transistors and others of the transistors are configured as PMOS transistors. Numerous variations and embodiments will be apparent in light of the present disclosure.

Method 500 begins with providing 505 a transistor structure that includes a body of semiconductor material between source and drain regions. In accordance with some embodiments, the body of semiconductor material can be a fin, nanowire, nanoribbon, nanosheet, or other form of material configured and arranged to function as a channel between the source and drain regions when the transistor is in use. The source and drain regions comprise a body of semiconductor material that can be or can include material that is continuous with the body of semiconductor material (channel region). In some embodiments, all or part of the source/drain material is compositionally distinct from the body (channel region) of semiconductor material. For example, the source/drain includes a core, a seed, part of a fin, or other inner region of semiconductor material upon which a second semiconductor material is deposited or grown to provide the source/drain region. Examples of such source/drain structures are discussed above with reference to FIGS. 1-3.

The source/drain material can include one or more suitable semiconductor materials, such as silicon, silicon germanium, silicon carbide, gallium, gallium arsenide, indium gallium arsenide, indium phosphate, or aluminum nitride, to name a few examples. The source/drain material can be doped with one or more dopants for n-type or p-type polarity. Dopant concentration N_{d} of the source/drain material can vary from one example to the next, but in some cases is in the range from 1E16 atoms/cm³ to 1E19 atoms/cm³, although higher or lower dopant concentrations can be used. Materials and dopants are discussed below in further detail.

FIG. 6A illustrates a perspective view of a nanowire transistor structure 100, in accordance with an embodiment of the present disclosure. In this example, the transistor structure 100 includes two nanowire transistors, each with source/drain material 114 on an upper portion of a fin 102 of semiconductor material extending up from a base 104 of the same material. Interlayer dielectric 120 material is on top of the base 104 and also surrounds the source/drain regions 105. A gate structure 124 is on nanoribbons 128 in the channel region of each transistor.

FIG. 7A illustrates a perspective view of a nanoribbon transistor structure 100, in accordance with an embodiment of the present disclosure. In this example, the transistor structure 100 includes two nanoribbon transistors, each with source/drain material 114 on nanoribbon cores 112. The source/drain material 114 and nanoribbon cores 112 are positioned over a fin stub 102a. A layer of isolation material 115 separates the source/drain material 114 from the fin stub 102a. Interlayer dielectric 120 material is on top of the base 104 and also surrounds the source/drain regions 105. A gate structure 124 is on the channel region of each transistor.

Method 500 continues with defining 520 one or more contact openings to expose one or more source/drain regions. Process 505 of providing the transistor structure can be performed such that the source/drain material is covered by an interlayer dielectric, such as an oxide. In such embodiments, defining 520 the contact opening(s) includes defining a via, channel, or other opening in the interlayer dielectric that exposes the source/drain material to be processed. Process 520 can be performed using any combination of lithography and wet or dry etch techniques. In one embodiment, an anisotropic etch process can be used to define the contact opening as a vertical trench or opening. In some embodiments, an isotropic wet etch may further be employed to remove residual dielectric material that is not well reached by the anisotropic etch, such as dielectric material below downward-facing surfaces of the source/drain material.

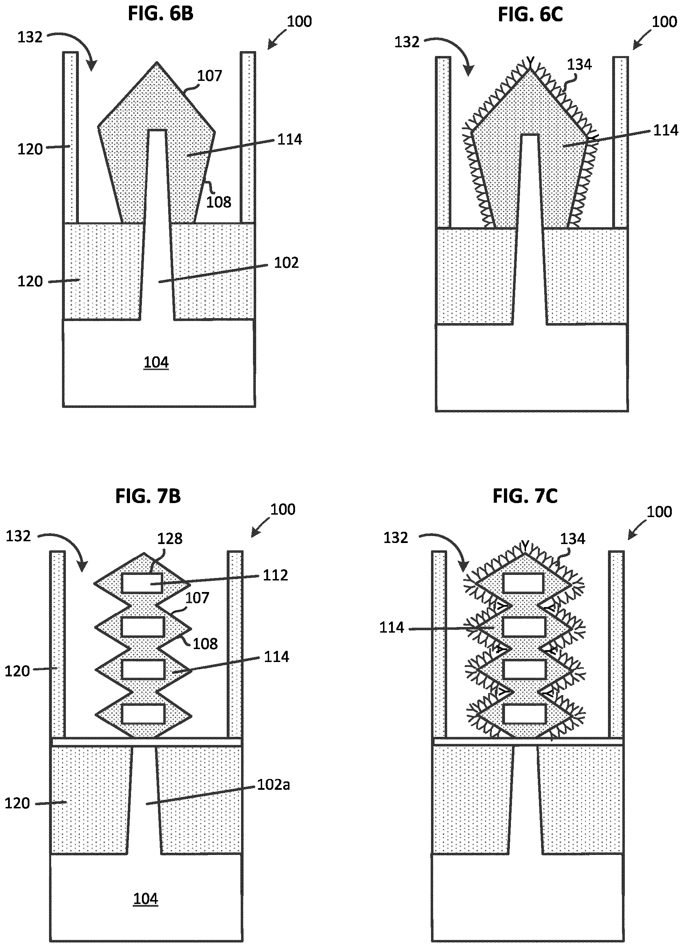

FIG. 6B and 7B are cross-sectional views of part of the transistor structures 100 of FIGS. 6A and 7A, respectively, where the section is taken through the source/drain region and is viewed along line B-B, in accordance with an embodiment of the present disclosure. In this example, only one source/drain region is shown. In FIG. 6B, the fin 102 extends up from the base 104 through a layer of interlayer dielectric 120 material. Source/drain material 114 is on three sides of the upper portion of the fin 102 and generally has a pentagonal cross-sectional shape that includes upward-facing surfaces 107 and downward-facing surfaces 108. A contact trench 132 has been defined in the interlayer dielectric 120 to expose the source/drain material 114. In other embodiments, the fin 102 is recessed to be flush with or below the top of the interlayer dielectric 120 material, followed by epitaxial deposition of source/drain material 114.

In FIG. 7B, nanoribbons are over a fin stub 102a extends up from the base 104 through a layer of interlayer dielectric 120 material. Source/drain material 114 surrounds the nanoribbons 128 and has a faceted shape that includes upward-facing surfaces 107 and downward-facing surfaces 108. A contact trench 132 has been defined in the interlayer dielectric 120 to expose the source/drain material 114.

Method 500 continues with applying 525 one or more monolayers of a dopant to the exposed source/drain material. In one embodiment, the dopant can be applied using wet processing techniques, such as spraying on a solution, spinning on a solution, or placing the exposed source/drain in an immersion bath containing the dopant molecule. In some wet processing techniques, the dopant molecule can be bonded to an organic molecule, can be dissolved in a solvent, or suspended in a carrier liquid. In other embodiments, the dopant can be applied using a chemical deposition technique, such as atomic layer deposition (ALD) or chemical vapor deposition (CVD). Dry or vapor-phase processing techniques can deposit the monolayer using dopant molecules in gas form (e.g., diborane gas for boron dopant, phosphine gas for phosphorous dopant). In some embodiments, a single monolayer is deposited on the exposed surfaces of the source/drain material, including any exposed side-facing, downward-facing, or surfaces blocked to direct access by other structures or portions of the source/drain. In other embodiments, a plurality of monolayers can be deposited, such as two, three, four or five monolayers, whether deposited in a single process or in successive processes. Applying 525 the monolayer of dopant material may result in a monolayer of dopant material along the sidewalls and bottom of the contact opening. Depending on the size of the dopant molecule, the dopant monolayer has a thickness from 0.5-10 nm, in accordance with some embodiments. Examples of suitable n-type dopants include phosphorus, arsenic, antimony, bismuth, and lithium. Examples of suitable p-type dopants include boron, aluminum, gallium, and indium. Other dopants include germanium, xenon, nitrogen, gold, and platinum.

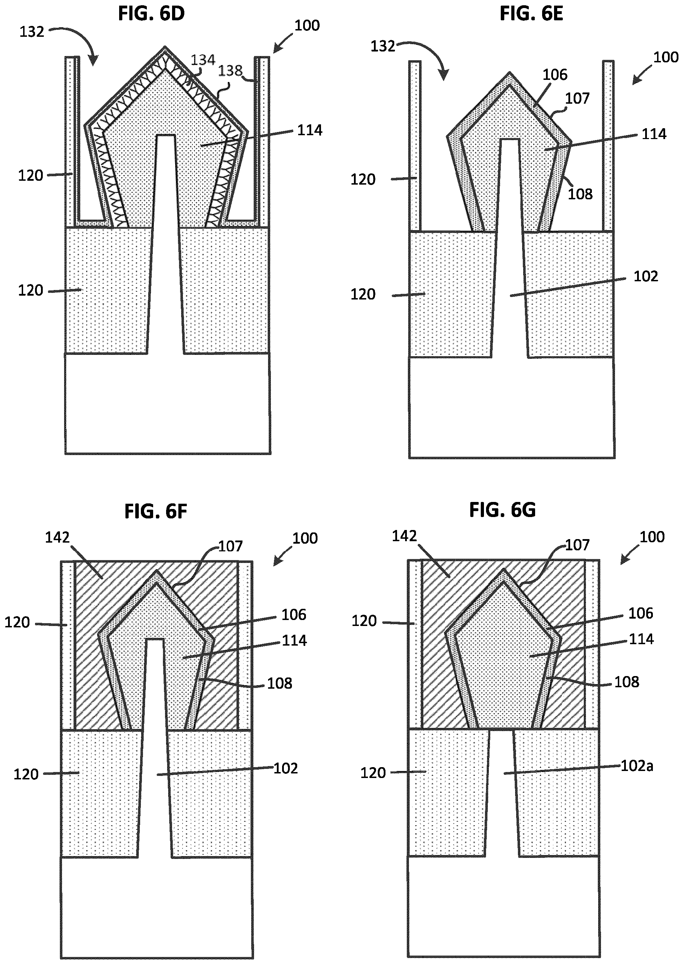

FIG. 6C illustrates the transistor structure 100 of 6B after depositing the monolayer 134 of dopant material on the surface of the source/drain material 114, according to an embodiment. Although not illustrated in FIG. 6C, the monolayer may also extend along the substantially vertical walls and floor of the contact opening (such as shown, for example, with respect to capping layer 138 in FIG. 6D, as will be discussed in turn). Further note that although one monolayer 134 is shown in this example case, other embodiments may include multiple monolayers 134, as previously explained.

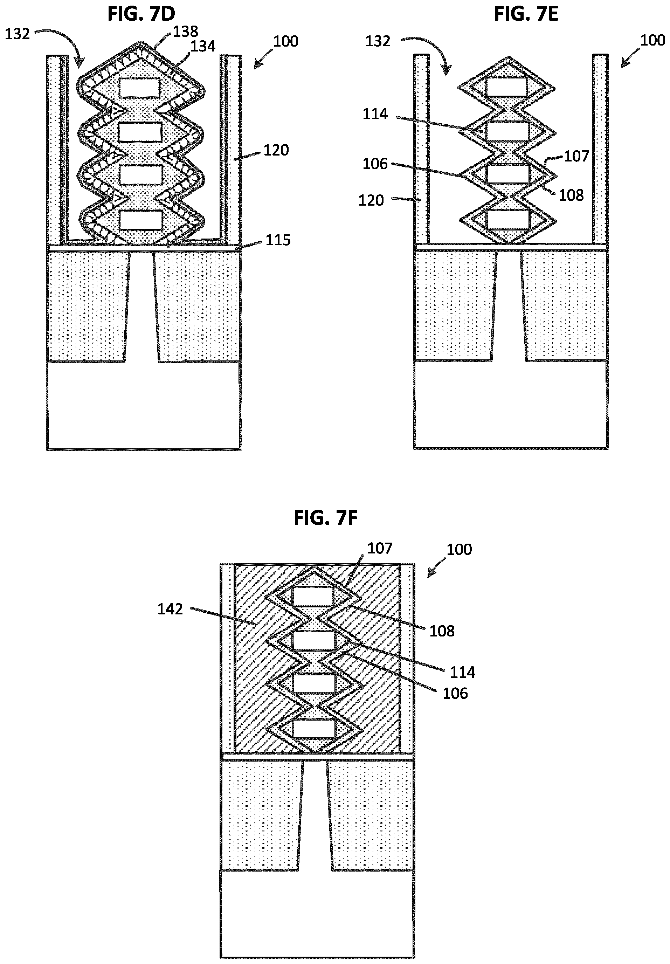

FIG.7C illustrates the transistor structure 100 of 7B after depositing the monolayer 134 of dopant material on the surface of the source/drain material 114, according to an embodiment. Although not illustrated in FIG. 7C, the monolayer may also extend along the substantially vertical walls and floor of the contact opening (such as shown, for example, with respect to capping layer 138 in FIG. 7D, as will be discussed in turn). Further note that although one monolayer 134 is shown in this example case, other embodiments may include multiple monolayers 134, as previously explained.

Method 500 continues with capping 530 the dopant monolayer(s). Capping 530 can be performed by depositing a chemical oxide over the dopant monolayer(s), such as by using a CVD or ALD process at a temperature of 400-500°C. In other embodiments, wet processing can be used to deposit an oxide or nitride capping layer over the dopant monolayer(s).

FIG. 6D illustrates the structure of FIG. 6C after depositing a silicon dioxide capping layer 138 over the monolayer 134, according to an embodiment. Note in this example case that the capping layer 138 also extends along portions of the interlayer dielectric 120 that are exposed along the sidewalls and bottom of the contact opening 132.

FIG. 7D illustrates the structure of FIG. 7C after depositing a silicon dioxide capping layer 138 over the monolayer 134, according to an embodiment. Note in this example case that the capping layer 138 also extends along portions of the interlayer dielectric 120 that are exposed along the sidewalls of the contact opening 132 and on the isolation material 115 along the bottom of the contact opening 132.

Method 500 continues with annealing 535 the source/drain to drive the dopant into the surface of the source/drain material. Without being bound to any particular theory, annealing 535 is believed to break bonds between the dopant molecules and organic molecules, thereby releasing the organic molecules. Annealing also causes the dopant molecules to migrate into the surface of the source/drain material. Annealing 535 can be performed, for example, at a temperature from 400-700°C for a few seconds to about 10 minutes.

Method 500 continues with removing 540 the capping material, if it remains. In some embodiments, annealing 535 removes part or all of the capping material. In other embodiments, some or all of the capping material may remain on the source/drain material 114 and/or the interlayer dielectric 120 defining the contact opening 132. Capping material can be removed 540 using, for example, a wet chemical etch, such as an acid etch to remove silicon dioxide. As deemed necessary, additional cleaning can be performed to remove residual organics, oxides, nitrides, and other species.

FIG. 6E illustrates the transistor structure 100 of FIG. 6D after annealing 535 and removing 540 the capping material, according to an embodiment. Note that the source/drain material 114 has an outer region 106 of relatively high doping concentration. The outer region 106 extends along both upward-facing surfaces 107 and downward-facing surfaces 108, in a relatively conformal manner. In some embodiments, the outer region 106 of the source/drain material 114 and/or the interlayer dielectric 120 defining the contact opening 132 may contain detectable traces of carbon as a result of organic molecules used during the monolayer doping process and anneal.

FIG. 7E illustrates the transistor structure 100 of FIG. 7D after annealing 535 and removing 540 the capping material, according to an embodiment. Note that the source/drain material 114 has an outer region 106 of relatively high doping concentration. The outer region 106 extends along both upward-facing surfaces 107 and downward-facing surfaces 108, in a relatively conformal manner. In some embodiments, the outer region 106 of the source/drain material 114 and/or the interlayer dielectric 120 defining the contact opening 132 may contain detectable traces of carbon as a result of organic molecules used during the monolayer doping process and anneal.

Method 500 continues with forming 545 the source/drain contact(s). In one embodiment, process 545 includes filling the contact opening with a conductive material, such as a metal or alloy, to define an electrical contact on the source/drain material. In doing so, the contact metal makes contact with surfaces of source/drain material that are exposed by the contact opening, including upward-facing surfaces, downward-facing surfaces, horizontal surfaces, and vertical surfaces. As such, the source/drain contact is a wrap-around contact (WAC), in accordance with some embodiments. In some embodiments, the source/drain contact(s) may include aluminum, tungsten, silver, titanium, copper, nickel, platinum, nickel-platinum, nickel-aluminum, ruthenium, molybdenum, or alloys thereof, although any suitably conductive contact metal or alloy may be used. Forming 545 the source/drain contact can be performed, for example, with chemical vapor deposition techniques using one or more suitable metals or alloys.

In some embodiments, additional layers may be present in the source and drain contact regions, such as adhesion layers (e.g., titanium nitride) and/or liner or barrier layers (e.g., tantalum nitride), if so desired. In some embodiments, a resistance-reducing layer may be present between a given source/drain material and its corresponding source/drain contact, such as a relatively highly doped (e.g., with dopant concentrations greater than 1E18, 1E19, 1E20, 1E21, or 1E22 atoms per cubic cm) intervening semiconductor material layer that is added onto the surface of the source/drain material, for example. In some such embodiments, the resistance-reducing layer may include semiconductor material and/or impurity dopants based on the included material and/or dopant concentration of the corresponding source or drain region, for example. In some embodiments, forming 545 source/drain contacts includes silicidation, germanidation, III-V-idation, and/or annealing, for example.

FIG. 6F illustrates the transistor structure 100 of FIG. 6E after forming 545 the source/drain contact 142, according to an embodiment. In this example, the source/drain contact 142 includes a metal fill that contacts the upward-facing surfaces 107 and downward-facing surfaces 108 of the source/drain material 114, and therefore is a wrap-around contact. As a result of the foregoing processes, the source/drain material 114 includes an outer region 106 of high dopant concentration (e.g., 1E19 atoms/cm³ and greater). Thus, the semiconductor/metal interface between source/drain contact 42 and the source/drain material 114 is a relatively high-quality interface (e.g., having relatively low contact resistance).

FIG. 6G shows a cross-sectional view taken through the source/drain region of a transistor structure 100 after completion of processes 525-540, in accordance with another embodiment. In this example, the fin 102 was recessed in the source/drain region during the source/drain processing, leaving a fin stub 102a in the interlayer dielectric 120 (or no fin at all as the case may be). Replacement source/drain material 114 was then deposited epitaxially. Note that in this example the replacement source/drain material 114 is on the fin stub 102a.

FIG. 7F illustrates the transistor structure 100 of FIG. 7E after forming 545 the source/drain contact 142, according to an embodiment. In this example, the source/drain contact 142 includes a metal fill that contacts the upward-facing surfaces 107 and downward-facing surfaces 108 of the source/drain material 114, and therefore is a wrap-around contact. As a result of the foregoing processes, the source/drain material 114 includes an outer layer or outer region 106 of high dopant concentration (e.g., 1E19 atoms/cm³ and greater). Thus, the semiconductor/metal interface between source/drain contact 42 and the source/drain material 114 is a relatively high-quality interface (e.g., having relatively low contact resistance).

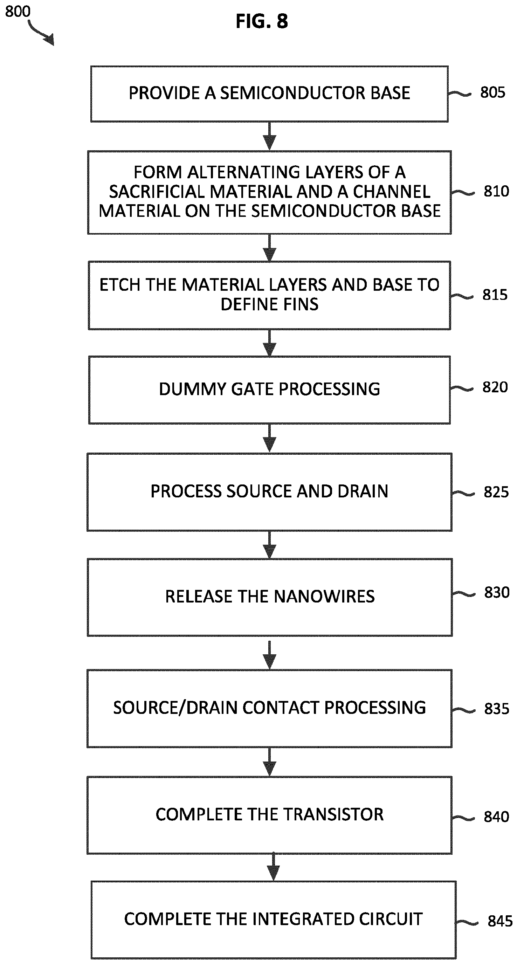

FIG. 8 illustrates a flow chart for a method 800 of fabricating a transistor device, in accordance with an embodiment of the present disclosure. In some embodiments, one or more processes in method 800 can be performed using method 500, such as source/drain contact processing 835. Similarly, some or all of processes in method 800 can be used in method 500. For example, providing 505 a transistor structure can be performed with processes 805-830. Method 800 is discussed in the context of fabricating a nanowire or nanoribbon transistor structure. The transistor structure applicable to method 800 is not limited to nanowire/nanoribbon transistors and alternately can be a fin-based transistor structure or a planar transistor structure, to name a few examples, and method 800 can be modified as suitable to achieve the desired transistor structure, as will be appreciated.

In one embodiment, method 800 begins with providing 805 a semiconductor base. The base may include any suitable material, such as monocrystalline semiconductor material that includes at least one of silicon (Si), germanium (Ge), carbon (C), tin (Sn), phosphorous (P), boron (B), arsenic (As), antimony (Sb), indium (In), and gallium (Ga) to name a few examples. In some embodiments, the base is bulk silicon, such as monocrystalline silicon. In other embodiments, the base can be any suitable semiconductor material, including silicon, silicon carbide (SiC), gallium nitride (GaN), and gallium arsenide (GaAs) to name a few examples. The base can be selected in some embodiments from III-V materials and group IV materials. Further, the base can comprise a semiconductor layer deposited or grown on a substrate, such as silicon carbide layer epitaxially grown on a sapphire substrate. In still other embodiments, the base can be bulk semiconductor material, such as a wafer sliced from a boule or other bulk semiconductor material.

The base in some embodiments may include a Si on insulator (SOI) structure where an insulator/dielectric material (e.g., an oxide material, such as silicon dioxide) is sandwiched between two Si layers (e.g., in a buried oxide (BOX) structure), or any other suitable starting substrate where the top layer includes Si. In some embodiments, the base may be doped with any suitable n-type and/or p-type dopant at a dopant concentration in the range of 1E16 to 1E22 atoms per cubic cm, for example. For instance, a silicon base can be p-type doped using a suitable acceptor (e.g., boron) or n-type doped using a suitable donor (e.g., phosphorous, arsenic) with a doping concentration of at least 1E16 atoms per cubic cm. However, in some embodiments, the base may be undoped/intrinsic or relatively minimally doped (such as including a dopant concentration of less than 1E16 atoms per cubic cm), for example. In some embodiments, the base is a silicon substrate consisting essentially of Si. In other embodiments, the base may primarily include Si but may also include other material (e.g., a dopant at a given concentration). Also, note that the base material may include relatively high quality or device-quality monocrystalline Si or other material that provides a suitable template or seeding surface from which other monocrystalline semiconductor material features and layers can be formed. Therefore, unless otherwise explicitly stated, a base as described herein is not intended to be limited to a base that only includes Si.

In some embodiments, the base may have a crystalline orientation described by a Miller index of (100), (110), or (111), or its equivalents, as will be apparent in light of this disclosure. Although the base in this example embodiment is shown for ease of illustration as having a thickness (dimension in the Y-axis direction) similar to that of other layers in the figures, the base may be relatively much thicker than the other layers, such as having a thickness in the range of 1 to 950 microns (or in the sub-range of 20 to 800 microns), for example, or any other suitable thickness or range of thicknesses as will be apparent in light of this disclosure. In some embodiments, the base may include a multilayer structure including two or more distinct layers that may or may not be compositionally different. In some embodiments, the base may include grading (e.g., increasing and/or decreasing) of one or more material concentrations throughout at least a portion of the material. In some embodiments, the base may be used for one or more other IC devices, such as various diodes (e.g., light-emitting diodes (LEDs) or laser diodes), various transistors (e.g., MOSFETs or TFETs), various capacitors (e.g., MOSCAPs), various microelectromechanical systems (MEMS), various nanoelectromechanical systems (NEMS), various radio frequency (RF) devices, various sensors, or any other suitable semiconductor or IC devices, depending on the end use or target application. Accordingly, in some embodiments, the structures described herein may be included in a system-on-chip (SoC) application, as will be apparent in light of this disclosure.

Method 800 continues with forming 810 alternating layers of sacrificial material and channel material on the base. In one embodiment, the sacrificial layer is formed directly on the base, followed by the channel material, and followed by additional layer pairs of sacrificial material and channel material, and finally followed by a top layer of sacrificial material. For example, the first (bottom) layer on the base is the sacrificial material and the last (top) layer is also the sacrificial material, thereby providing layers of the channel material between layers of the sacrificial material. In one example embodiment, the base is bulk silicon (Si), the sacrificial material is silicon germanium (SiGe), and the channel material is silicon doped with a suitable dopant and concentration. In another example, the base is graphene, the sacrificial material is gallium, and the channel material is gallium arsenide (GaAs). Other material combinations can also be used, as will be appreciated.

Each layer of sacrificial material or channel material can be formed using any suitable processing, such as one or more deposition or epitaxial growth processes, as will be apparent in light of this disclosure. In one embodiment, alternating layers of sacrificial material and channel material can be formed using layer-by-layer epitaxial growth, where the sacrificial material can subsequently be removed to release nanowires of the channel material. For instance, in an example embodiment, a given channel layer may include alternating layers of Group IV and Group III-V semiconductor material, where either the Group IV or Group III-V material is sacrificial, to enable the formation of one or more nanowires. In some embodiments, a given layer of channel material may include a vertical channel height (dimension in the Y-axis direction) in the range of 5nm to 50 nm (or in a subrange of 5-45, 5-40, 5-35. 5-30. 5-25, 5-20, 5-15, 5-10, 10-40, 10-30, 10-20, 15-40, 15-30, 15-20, 20-40, 20-30 and 30-40 nm) and/or a maximum vertical thickness of at most 50, 40, 30, 25, 20, 15, or 10 nm, for example. Other suitable materials and channel height requirements or thresholds will be apparent in light of this disclosure.

In some embodiments, multiple different channel materials may be formed on different areas of the base, such as for CMOS applications, for example. For instance, a first channel material may be formed on a first area of the base to be used for one or more p-channel transistor devices (e.g., one or more PMOS devices) and a second channel material may be formed on a second area of the base to be used for one or more n-channel transistor devices (e.g., one or more NMOS devices). By selecting the subfin material to have the desired properties, multiple different channel materials can be grown. For instance, in some such embodiments, the first channel material may include a n-type Group III-V or Group IV material and a second channel material may include a p-type Group III-V or Group IV material.

In some embodiments employing multiple different channel materials, the first channel material may include Group IV semiconductor material (e.g., Si, SiGe, Ge, etc.) and the second channel material may include Group III-V semiconductor material (e.g., GaAs, InGaAs, InP, etc.). In general, a given channel material may include monocrystalline Group IV semiconductor material and/or Group III-V semiconductor material. For instance, in a beaded-fin transistor configuration, the channel region may include both Group IV semiconductor material (e.g., for the broader or narrower portions) and Group III-V semiconductor material (e.g., for the other of the broader or narrower portions). Note that the multiple different channel materials may be formed using any suitable techniques, such as masking, depositing, and removing the masking as desired to form any number of compositionally different channel materials. Numerous different channel material configurations and variations will be apparent in light of this disclosure.

Method 800 continues with defining 815 fins, in accordance with one embodiment. For example, each fin has a subfin portion of base material and an upper fin portion of alternating layers of sacrificial material and channel material. In embodiments where blanket layers of material are formed on the base in process 810 for example, regions to be processed 815 into fins are masked, followed by etching the surrounding regions to define one or more fins. For instance, the an anisotropic etch proceeds substantially vertically through the upper fin portion to define isolation trenches between adjacent fins. In some embodiments, the etch process proceeds into the base to define a fin that includes a subfin portion of the base material and an upper fin portion of alternating layers of sacrificial material and channel material. In some embodiments, the etch process defines groups of parallel fins extending vertically up from the base. In other embodiments, the etch defines planar or 3D transistor structures having an H shape, where the channel region corresponds to the beam extending between the source and drain regions represented by the vertical bars of the H.

In other embodiments, for example, the alternating layers of sacrificial material and channel material are formed on the base by growth or deposition in a trench. For example, the trench is an aspect ratio trapping trench ("ART" trench) defined in a layer of insulating material, such as silicon dioxide (SiO₂) formed by thermal oxidation or by deposition using a suitable one of the aforementioned techniques. The insulating material is then patterned and etched to define trenches that extend to a substrate or other material layer. A base material can be formed directly on the substrate in the lower portion of the trench, followed by alternating layers of the sacrificial material and channel material. The insulating material can be recessed to expose all or part of the fin. In some embodiments, the insulating material is recessed to the top of the subfin (i.e., base material) to expose only the layer stack of sacrificial material and channel material in the upper portion of the fin. In other embodiments, the insulating material is recessed completely to expose the entire subfin, or the insulating material is recessed to a level below the first layer of sacrificial material to expose a portion of the subfin. Numerous variations and embodiments will be apparent in light of the present disclosure.

In yet other embodiments, defining 815 fins may be performed using a replacement fin-based approach. In one embodiment, the replacement fin-based approach includes forming fins on the base, such as by patterning and etching bulk semiconductor material. Shallow trench isolation (STI) material is the formed around those fins, followed by recessing the native-to-substrate fins to define fin-shaped trenches in the STI material. Subfin material and alternating layers of sacrificial material and channel material can then be formed in the fin-shaped trenches. In one embodiment, the replacement fin approach continues with removing the STI material and forming an insulating material on the base between the subfins, leaving the layer stack of alternating sacrificial material and channel material exposed.

In some embodiments, the subfin is a Group IV semiconductor material, such as single-crystal silicon or germanium. In other embodiments, the subfin material is a Group III-V semiconductor material, such as GaAs, InGaAs, AlGaAs, or AlAs, to name a few examples. In some embodiments, the subfin material may or may not be doped with a suitable dopant (e.g., boron, phosphorous, and/or arsenic). In embodiments where the subfin material is doped, it may be n-type doped (e.g., with phosphorous or arsenic) or p-type doped (e.g., with boron) at a dopant concentration in the range of 1E16 to 1E22 atoms per cubic cm, for example. In some embodiments, the subfins may have a multilayer structure including two or more distinct layers (that may or may not be compositionally distinct). In some embodiments, the subfins may include grading (e.g., increasing and/or decreasing) of one or more material concentrations throughout at least a portion of the subfin material.

In some embodiments, each fin may include a vertical fin height (dimension in the Y-axis direction) in the range of 10-500 nm (or in a subrange of 20-50, 20-100, 20-200, 20-300, 20-400, 50-100, 50-200, 50-300, 50-400, 50-500, 100-250, 100-400, 100-500, 200-400, or 200-500 nm) and/or a maximum vertical fin height of at most 500, 450, 400, 350, 300, 250, 200, 150, 100, or 50 nm, for example. In some embodiments, each fin may include a horizontal fin width (dimension in the X-axis direction) in the range of 2-50 nm (or in a subrange of 2-5, 2-10, 5-10, 5-20, 5-30, 5-50, 10-20, 10-30, 10-50, 20-30, 20-50, or 30-50 nm) and/or a maximum horizontal fin width of at most 50, 30, 20, 10, or 5 nm, for example. In some embodiments, the ratio of fin height to fin width may be greater than 1, such as greater than 1.5, 2, 2.5, 3, 3.5, 4, 4.5, 5, 6, 7, 8, 9, 10, 15, 20, or greater than any other suitable threshold ratio, as will be apparent in light of this disclosure. Other suitable materials and thickness values/ranges/thresholds will be apparent in light of this disclosure.

In some embodiments, the base or subfin material may be oppositely type doped relative to the overlying upper fin material (e.g., of the source and drain regions) to provide a tunnel diode configuration to help reduce or eliminate parasitic leakage (e.g., subthreshold leakage). For instance, in some embodiments, the subfin material may be intentionally p-type doped (e.g., with a doping concentration of at least 1E16, 5E16, 1E17, 5E17, 1E18, 5E18, or 1E19 atoms per cubic cm) if the overlying material is to be n-type doped, or vice versa.

Method 800 continues with forming 820 a dummy gate structure on the channel region of the fins. In one embodiment, forming 820 the dummy gate structure may include deposition of a dummy gate oxide, deposition of a dummy gate electrode (e.g., poly-Si), and optionally, deposition and patterning of a hardmask. Gate spacers are formed along opposite sides of the dummy gate electrode. For example, the gate spacers comprise silicon nitride (Si₃N₄) or other suitable material, as will be appreciated.

Method 800 continues with processing 825 the source/drain regions using any suitable techniques, in accordance with an embodiment of the present disclosure. In some embodiments, such as for fin-based transistor structures, processing 825 the source and drain regions can be performed by etching at least a portion of the exposed source and drain portion of the fins to remove the layer stack, and forming replacement source and drain material using any suitable techniques, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example. The exposed source/drain regions of the fins need not be completely removed; instead, the material in the layer stack at the source/drain regions is converted to final source/drain regions by doping, implantation, and/or cladding with a source/drain material or other suitable processing, for example.

In other embodiments, such as for nanoribbon transistor structures, the nanowires in the source/drain region remain in preparation for cladding the nanoribbon ends with material of the source/drain. A cladding approach contrasts other nanoribbon fabrication processing techniques in which the nanoribbons in the source/drain region are removed completely prior to epitaxial deposition of replacement source/drain material. In one example, the portion of the fin in the source/drain region is etched to release the nanoribbons in the source/drain region, followed by epitaxial deposition of source/drain cladding material on the exposed nanoribbons in the source/drain region. Example techniques for releasing the nanoribbons or nanowires is discussed in more detail below in process 830.

In some embodiments, the source and drain regions may be formed one polarity at a time, such as performing processing for one of n-type and p-type regions, and then performing processing for the other of the n-type and p-type regions. In some embodiments, the source and drain regions may include any suitable doping scheme, such as including suitable n-type and/or p-type dopant (e.g., in a concentration in the range of 1E16 to 1E22 atoms per cubic cm). However, in some embodiments, at least one source or drain region may be undoped/intrinsic or relatively minimally doped, such as including a dopant concentration of less than 1E16 atoms per cubic cm, for example.

Method 800 continues with releasing 830 nanowires in the channel region. Process 830 may begin with removing the dummy gate electrode between the gate spacers to expose the channel region of the fin. For example, a polycrystalline silicon dummy gate electrode can be removed using a wet etch process (e.g., nitric acid/hydrofluoric acid), an anisotropic dry etch, or other suitable etch process, as will be appreciated. At this stage of processing, the layer stack of alternating layers of channel material and sacrificial material is exposed in the channel region. The channel region extends between and contacts the source and drain regions, where ends of the layer stack in the are protected by the gate spacers. The sacrificial material in the layer stack can then be removed by etch processing, in accordance with some embodiments.

Etching the sacrificial material may be performed using any suitable wet or dry etching process such that the etch process selectively removes the sacrificial material and leaves intact the channel material. In one embodiment, the sacrificial material is silicon germanium (SiGe) and the channel material is electronic grade silicon (Si). For example, a gas-phase etch using an oxidizer and hydrofluoric acid (HF) has shown to selectively etch SiGe in SiGe/Si layer stacks. In another embodiment, a gas-phase chlorine trifluoride (ClF₃) etch is used to remove the sacrificial SiGe material. The etch chemistry can be selected based on the germanium concentration, nanowire dimensions, and other factors, as will be appreciated. After removing the SiGe sacrificial material, the resulting channel region includes silicon nanowires extending between the source and drain regions of the fin, where ends of the nanowires (e.g., silicon) contact the source and drain structures and remain at least partially protected by the gate spacers. In some embodiments, the nanowires have a rectangular cross-sectional shape at this stage of processing. For example, the cross-sectional shape is square, rectangular (e.g., a nanoribbon), or trapezoidal.

Process 830 may include one or more cleaning cycles that include growth of a thin oxide layer on the nanowires and removing the oxide layer. Process 830 may include annealing the nanowire(s) to cause the semiconductor material (e.g., silicon) to reflow, thereby rounding corners and/or smoothing protrusions on the surface of the nanowire. For example, a high-temperature annealing process, sometimes referred to as rapid thermal anneal (RTA) can be used. Such processing has a temperature and length of time sufficient to cause reflow of the silicon (or other) material.

Method 800 continues with processing 835 the source/drain contact(s). In one embodiment, method 500 can be used to form source/drain contacts that include an outer layer of highly doped source/drain material. In other embodiments, the source/ drain contacts can be formed using any suitable techniques, such as forming contact trenches in an ILD layer over the respective source/drain regions and then depositing metal or metal alloy (or other suitable electrically conductive material) in the trenches. In some embodiments, forming source/drain contacts may include silicidation, germanidation, III-V-idation, and/or annealing processes, for example. In some embodiments, the source and drain contacts may include aluminum or tungsten, ruthenium, and/or molybdenum, although any suitable conductive metal or alloy can be used, such as silver, nickel-platinum, and nickel-aluminum, for example. In some embodiments, one or more of the source/drain contacts may include a resistance reducing metal and a contact plug metal, or just a contact plug, for instance. Example contact resistance reducing metals include, for instance, nickel, aluminum, titanium, gold, gold-germanium, nickel-platinum, nickel aluminum, and/or other such resistance reducing metals or alloys. Example contact plug metals include, for instance, aluminum, copper, nickel, platinum, titanium, or tungsten, or alloys thereof, although any suitably conductive contact metal or alloy may be used. In some embodiments, additional layers may be present in the source and drain contact regions, such as adhesion layers (e.g., titanium nitride) and/or liner or barrier layers (e.g., tantalum nitride), if so desired. In some embodiments, a contact resistance reducing layer may be present between a given source or drain region and its corresponding source or drain contact, such as a relatively highly doped (e.g., with dopant concentrations greater than 1E18, 1E19, 1E20, 1E21, or 1E22 atoms per cubic cm) intervening semiconductor material layer, for example. In some such embodiments, the contact resistance reducing layer may include semiconductor material and/or impurity dopants based on the included material and/or dopant concentration of the corresponding source or drain region, for example.

Method 800 continues with completing 835 the transistor. In one embodiment, completing 835 the transistor may begin with processing the final gate stack, in accordance with some embodiments. In some embodiments, the gate stack is formed using a gate-last fabrication flow, which may be considered a replacement gate or replacement metal gate (RMG) process. In embodiments utilizing a nanowire channel structure, the gate stack may substantially (or completely) surround each nanowire body portion, such as wrapping around at least 80, 85, 90, 95% or more of each nanowire body. Processing the final gate stack includes depositing a gate dielectric on the exposed nanowire bodies in the channel region, followed by formation of a gate electrode in contact with the gate dielectric. Any suitable technique can be used, including spin-coating or CVD deposition, for example. The gate dielectric may include, for example, any suitable oxide (such as silicon dioxide), high-k dielectric material, and/or any other suitable material as will be apparent in light of this disclosure. Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. In some embodiments, the gate dielectric can be annealed to improve its quality when high-k dielectric material is used. The gate electrode may include a wide range of materials, such as polysilicon or various suitable metals or metal alloys, such as aluminum (Al), tungsten (W), titanium (Ti), tantalum (Ta), copper (Cu), titanium nitride (TiN), or tantalum nitride (TaN), for example.

In some embodiments, gate dielectric and/or gate electrode may include a multilayer structure of two or more material layers, for example. For instance, in some embodiments, a multilayer gate dielectric may be employed to provide a more gradual electric transition from the channel region to the gate electrode, for example. In some embodiments, the gate dielectric and/or gate electrode may include grading (e.g., increasing and/or decreasing) the content or concentration of one or more materials in at least a portion of the feature(s). In some embodiments, one or more additional layers may also be present in the final gate stack, such as one or more relatively high or low work function layers and/or other suitable layers. Note that the gate dielectric may also be used to form replacement gate spacers on one or both sides of the nanowire body, such that the gate dielectric is between the gate electrode and one or both gate spacers, for example. Numerous different gate stack configurations will be apparent in light of this disclosure.

Method 800 continues with completing 845 a general integrated circuit (IC) as desired, in accordance with some embodiments. Such additional processing to complete an IC may include back-end or back-end-of-line (BEOL) processing to form one or more metallization layers and/or to interconnect the transistor devices formed, for example. Any other suitable processing may be performed, as will be apparent in light of this disclosure.

Note that the processes in method 800 are shown in a particular order for ease of description. However, one or more of the processes may be performed in a different order or may not be performed at all, in accordance with some embodiments. Numerous variations on method 700 and the techniques described herein will be apparent in light of this disclosure.

### EXAMPLE SYSTEM

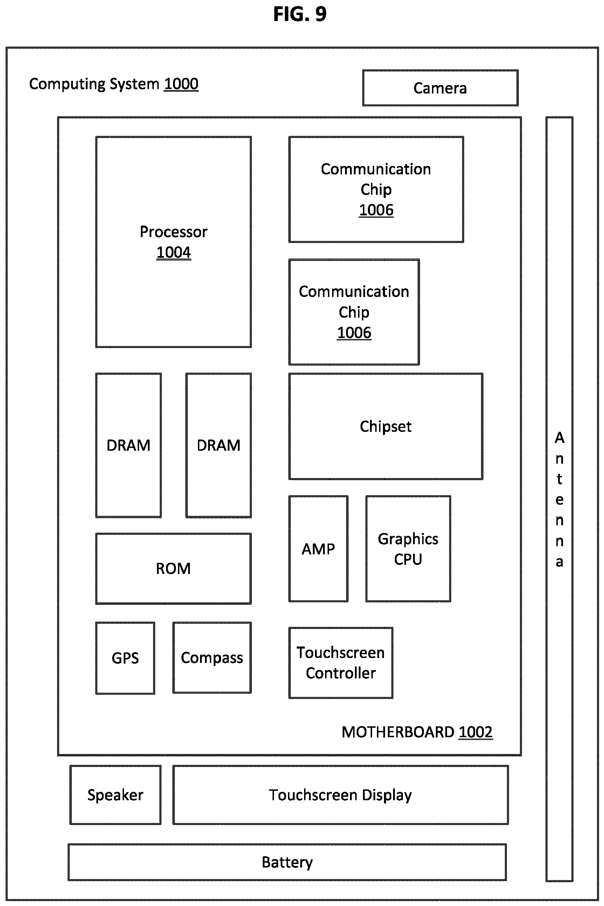

FIG. 9 illustrates a computing system 1000 implemented with integrated circuit structures and/or transistor structures formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### FURTHER EXAMPLE EMBODIMENTS

The following examples pertain to further embodiments, from which numerous permutations and configurations will be apparent.

Example 1 is an integrated circuit comprising a body of semiconductor material; a source or drain region including semiconductor material in contact with the body, wherein the semiconductor material of the source or drain region includes an outer region having a dopant concentration of at least 1E19 atoms/cm³, the outer region defining multiple contact surfaces of the source or drain region and extending into the source or drain region to a depth of at least 1 nm; and a contact on the multiple contact surfaces of the source or drain region, the contact comprising a metal.

Example 2 includes the subject matter of Example 1, wherein a dopant concentration in remaining region of the semiconductor material of the source or drain region is less than the dopant concentration of the outer region.

Example 3 includes the subject matter of any one of Examples 1 or 2, wherein the dopant concentration of the outer region is continuous along the entire interface between the contact and the outer region.

Example 4 includes the subject matter of any one of Examples 1-3, wherein the outer region is conformal along the multiple contact surfaces of the source or drain region.

Example 5 includes the subject matter of any one of Examples 1-4, wherein the contact is a wrap-around contact in that it wraps all the way around the source or drain region.

Example 6 includes the subject matter of any one of Examples 1-5, wherein the body is part of a fin.

Example 7 includes the subject matter of any one of Examples 1-5, wherein the body includes one or more nanowires or nanoribbons or nanosheets.

Example 8 includes the subject matter of any one of Examples 1-7, comprising a resistance-reducing layer between the contact and the outer region of the semiconductor material of the source or drain region, the resistance-reducing layer selected from (i) an adhesion layer, (ii) a diffusion barrier, and (iii) a workfunction metal layer.

Example 9 includes the subject matter of any one of Examples 1-8, wherein the outer region comprises carbon.

Example 10 includes the subject matter of any one of Examples 1-9, wherein the outer region has a depth of 5 nm to 15 nm.

Example 11 includes the subject matter of any one of Examples 1-10, wherein the source or drain region includes a core of a first semiconductor material and a second semiconductor material over the core, wherein the second semiconductor material is compositionally distinct from the first semiconductor material, and the outer region is part of the second semiconductor material.

Example 12 includes the subject matter of Example 11, wherein the core includes one or more nanoribbons.

Example 13 includes the subject matter of any one of Examples 1-12, wherein the contact comprises at least one of ruthenium or molybdenum.

Example 14 is an integrated circuit comprising a first body of n-type semiconductor material; a first source or drain region in contact with the first body; a second body of p-type semiconductor material arranged vertically above or below the first body; and a second source or drain region in contact with the second body; wherein material of the first source or drain region includes a first outer region having a first dopant concentration of at least 1E19 atoms/cm³, the first outer region defining multiple contact surfaces of the first source or drain region and extending into the first source or drain region to a depth of at least 5 nm; wherein the second source or drain region includes a second outer region having a second dopant concentration of at least 1E19 atoms/cm³, the second outer region defining multiple contact surfaces of the second source or drain region and extending into the second source or drain region to a depth of at least 5 nm; a first contact on the multiple contact surfaces of the first source or drain region, the first contact comprising a metal; and a second contact on the multiple contact surfaces of the second source or drain region, the second contact comprising a metal; wherein the multiple contact surfaces of the first and/or second source or drain regions includes one or more side-facing or downward-facing surface.

Example 15 includes the subject matter of Example 14, wherein the first body is arranged in a spaced-apart, vertical stack with the second body.

Example 16 includes the subject matter of any one of Examples 14-15, wherein the first body includes a first plurality of nanoribbons or nanowires or nanosheets, and the second body comprises a second plurality of nanoribbons or nanowires or nanosheets.

Example 17 includes the subject matter of any one of Examples 14-16, wherein the first outer region has a peak dopant concentration of at least 1E20 atoms/cm³.

Example 18 includes the subject matter of Example 17, wherein the peak dopant concentration of the first outer region is within 2 nm of an outer surface of the first source or drain region.

Example 19 includes the subject matter of any one of Examples 17-18, wherein the outer region of the second source or drain has a peak dopant concentration of at least 1E20 atoms/cm³.

Example 20 includes the subject matter of Example 19, wherein the peak dopant concentration of the second outer region is within 2 nm of an outer surface of the second outer region.

Example 21 includes the subject matter of any one of Examples 14-20, comprising one or more material layers between the first contact and the first outer layer, the one or more material layers selected from (i) an adhesion layer, (ii) a diffusion barrier layer, and (iii) a workfunction metal layer.

Example 22 includes the subject matter of any one of Examples 14-21, wherein the first contact and/or the second contact comprises ruthenium and/or molybdenum.

Example 23 is an integrated circuit comprising a body of semiconductor material; a source or drain region including semiconductor material in contact with the body, wherein the semiconductor material of the source or drain region includes an outer region comprising a dopant, the outer region defining multiple contact surfaces of the source or drain region and extending into the source or drain region to a depth of at least 1 nm, and wherein the multiple contact surfaces of the source or drain region include one or more downward facing surfaces and one or more upward facing surfaces, and the dopant of the outer region continuously extends along the one or more downward facing surfaces and the one or more upward facing surfaces; and a contact on the multiple contact surfaces of the source or drain region, including the one or more downward facing surface, the contact comprising a metal.

Example 24 includes the subject matter of Example 23, wherein the outer region has a first dopant concentration of the dopant of at least 1E19 atoms/cm³, and a remaining region of the semiconductor material of the source or drain region is less than 1E19 atoms/cm³.

Example 25 includes the subject matter of any one of Examples 23-24, wherein the outer region of semiconductor material of the source or drain region has a peak dopant concentration of at least 1E21 atoms/cm³.

Example 26 includes the subject matter of any one of Examples 23-25, wherein the body is part of a fin.

Example 27 includes the subject matter of any one of Examples 23-26, wherein the body includes one or more nanowires or nanoribbons or nanosheets.

Example 28 includes the subject matter of any one of Examples 23-27, wherein the outer region comprises carbon.

Example 29 includes the subject matter of any one of Examples 23-28, wherein the outer region has a depth of 2 nm to 10 nm.

Example 30 includes the subject matter of any one of Examples 23-29, wherein the source or drain region includes a core of a first semiconductor material and a second semiconductor material over the core, wherein the second semiconductor material is compositionally distinct from the first semiconductor material, and the outer region is part of the second semiconductor material.

Example 31 includes the subject matter of Example 30, wherein the core includes one or more nanoribbons.

Example 32 includes the subject matter of any one of Examples 23-31, wherein the metal of the contact includes ruthenium and/or molybdenum.

Example 33 includes the subject matter of any one of Examples 1-32, wherein the core includes one or more nanoribbons.

Example 34 is a method comprising providing a transistor structure having source/drain material; defining a contact opening to expose the source/drain material; applying a monolayer of dopant molecules on the source/drain material; annealing the monolayer; and forming a source/drain contact on the source/drain material.

Example 35 includes the subject matter of Example 34, comprising capping the monolayer with an oxide or a nitride capping material; and removing the capping material after annealing the monolayer.

Example 36 includes the subject matter of any one of Examples 34-35, wherein the monolayer is on at least one side-facing or downward-facing surface of the source/drain material.

Example 37 includes the subject matter of any one of Examples 34-36, wherein the source/drain contact is a wrap-around contact that abuts at least one side-facing or downward-facing surface of the source/drain material.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future-filed applications claiming priority to this application may claim the disclosed subject matter in a different manner and generally may include any set of one or more limitations as variously disclosed or otherwise demonstrated herein.

## Claims

1. An integrated circuit comprising:
a body of semiconductor material;
a source or drain region including semiconductor material in contact with the body, wherein the semiconductor material of the source or drain region includes an outer region having a dopant concentration of at least 1E19 atoms/cm³, the outer region defining multiple contact surfaces of the source or drain region and extending into the source or drain region to a depth of at least 1 nm; and
a contact on the multiple contact surfaces of the source or drain region, the contact comprising a metal.

2. The integrated circuit of claim 1, wherein a dopant concentration in remaining region of the semiconductor material of the source or drain region is less than the dopant concentration of the outer region.

3. The integrated circuit of claim 1 or 2, wherein the dopant concentration of the outer region is continuous along the entire interface between the contact and the outer region.

4. The integrated circuit of any one of claims 1 through 3, wherein the outer region is conformal along the multiple contact surfaces of the source or drain region.

5. The integrated circuit of any one of claims 1 through 4, wherein the contact is a wrap-around contact in that it wraps all the way around the source or drain region.

6. The integrated circuit of any one of claims 1 through 5, wherein the body is part of a fin.

7. The integrated circuit of any one of claims 1 through 5, wherein the body includes one or more nanowires or nanoribbons or nanosheets.

8. The integrated circuit of any one of claims 1 through 7, comprising a resistance-reducing layer between the contact and the outer region of the semiconductor material of the source or drain region, the resistance-reducing layer selected from (i) an adhesion layer, (ii) a diffusion barrier, and (iii) a workfunction metal layer.

9. The integrated circuit of any one of claims 1 through 8, wherein the outer region comprises carbon.

10. The integrated circuit of any one of claims 1 through 9, wherein the outer region has a depth of 5 nm to 15 nm.

11. The integrated circuit of any one of claims 1 through 10, wherein the source or drain region includes a core of a first semiconductor material and a second semiconductor material over the core, wherein the second semiconductor material is compositionally distinct from the first semiconductor material, and the outer region is part of the second semiconductor material.

12. The integrated circuit of claim 11, wherein the core includes one or more nanoribbons.

13. The integrated circuit of any one of claims 1 through 12, wherein the contact comprises at least one of ruthenium or molybdenum.

14. A method comprising:
providing a transistor structure having source/drain material;
defining a contact opening to expose the source/drain material;
applying a monolayer of dopant molecules on the source/drain material;
annealing the monolayer; and
forming a source/drain contact on the source/drain material.

15. The method of claim 14, comprising:
capping the monolayer with an oxide or a nitride capping material; and
removing the capping material after annealing the monolayer.
